# EUROPEAN PATENT APPLICATION

(11) **EP 4 517 819 A1**
(43) Date of publication of application: **05.03.2025**
(21) Application number: 24193041.1
(22) Date of filing: 06.08.2024
(51) Int. Cl.: H01L 23/495, H01L 23/00, H01L 21/48, H01L 23/31

(54) **METHOD OF MANUFACTURING SEMICONDUCTOR DEVICES, CORRESPONDING COMPONENT AND SEMICONDUCTOR DEVICE**

(30) Priority: 29.08.2023 IT 202300017700
(71) Applicant: STMicroelectronics International N.V., 1228 Plan-les-Ouates, Geneva (CH)
(72) Inventor: MAZZOLA, Mauro, 24040 Calvenzano (Bergamo) (IT); DE SANTA, Matteo, 20883 Mezzago (Monza Brianza) (IT)
(74) Representative: Buzzi, Notaro & Antonielli d'Oulx S.p.A.

(57) **Abstract**

A semiconductor die (14B) is arranged at a die mounting location (12A) of a substrate (12) that comprises an array of electrically conductive leads (12B) arranged laterally of the die mounting location (12A) .

The semiconductor die (14B) is electrically coupled with one or more electrically conductive leads (12B) in the array of electrically conductive leads (12B) via an electrical coupling member (100) applied onto the semiconductor die (14B).

The electrical coupling member (100) comprises a plurality of electrically conductive pads (102) having respective first and second electrically conductive ribbons (108) protruding therefrom. The first and second electrically conductive ribbons (108) have proximal ends at the electrically conductive pad (102) and distal ends away from the electrically conductive pad (102).

The distal ends of the first and second electrically conductive ribbons (108) are electrically coupled to the semiconductor die (14B) arranged at the die mounting location (12A) of the substrate (12) and respective electrically conductive leads (12B), to provide electrical coupling therebetween.

## Description

### Technical field

The description relates to manufacturing semiconductor devices.

Solutions as described herein can be applied to integrated circuit (IC) power semiconductor devices such as power QFN packages for automotive products, for instance.

### Background

In power semiconductor devices, the current transferred from the high-power section to the output pads of the device can be significant.

Clips or ribbons are used for that purpose in the place of wires.

Clips are currently stamped from flat material and are provided with centering features such as pins that facilitate centering and keeping the clips in position during processing.

In small power QFNs and/or if several channels are desired in the final package, more pads are needed and the dimensions for the centering features on leadframe and clips may become relatively small.

Furthermore, clips singulation and handling may become difficult due to tighter and elongated clips shape.

Another approach is based on the use of electrically conductive ribbons to provide electrical coupling between the power section of a (integrated circuit, IC) semiconductor device and the outer pads.

These ribbons are bonded via ultrasonic wedge-bonding and such a bonding method may severely damage the (relatively small) outer pads and/or the die bonding pads provided on the semiconductor die.

Document US 2017288564 A1 discloses a second lead frame set onto a conductive layer and a busbar. The second lead frame has holes previously formed at opposite ends thereof, and pieces of solder material or solder pieces are inserted into the holes. The solder pieces are vibrated by an ultrasonically vibrating tool, whereby the solder pieces are melted without having a high temperature. The second lead frame is thus bonded to the conductive layer and the busbar. A semiconductor element and the busbar are connected by a first lead frame and the second lead frame. The connection structure thereof is such that the second lead frame to be bonded by ultrasonic bonding or other bonding methods is not directly in contact with the semiconductor element, which eliminates the risk of damage to the semiconductor element.

Document US 2013161801 A1 discloses a module including a DCB substrate and a discrete device mounted on the DCB substrate. The discrete device comprises a leadframe, a semiconductor chip mounted on the leadframe and an encapsulation material covering the semiconductor chip.

Document JP S61237456 A discloses a semiconductor chip bonded directly with a metallic conductor pattern on an insulating plate only through a solder material in order to avoid the increase of thermal resistance, and to reduce thermal resistance.

### Object and summary

Solutions as described herein aim at addressing the issues discussed in the foregoing.

Such an object can be achieved via a method having the features set forth in the claims that follow.

One or more embodiments relate to a corresponding component. An electrical coupling member for use in manufacturing (power) semiconductor devices and suited to be provided by a supplier to a manufacturer of semiconductor devices can be exemplary of such a component

One or more embodiments relate to a semiconductor device comprising such a component.

The claims are an integral part of the technical teaching provided in respect of the embodiments.

In solutions as described herein, an electrical coupling member is provided to electrically couple an integrated circuit semiconductor die to one or more (power) leads.

In solutions as described herein, an electrical coupling member may be formed via premolding technology.

Solutions as described herein contemplate providing a leadframe, mounting a die thereon, applying an electrical coupling member to provide the desired electrical couplings between the die and leads in the leadframe.

### Brief description of the several views of the drawings

One or more embodiments will now be described, by way of example only, with reference to the annexed figures, wherein:
Figure 1 is a plan view illustrative of the structure of a power semiconductor device,
Figure 2 is illustrative of a processing step of a plurality of coupling members according to embodiments of the present description,
Figures 3A and 3B are illustrative of steps in the manufacturing process of a coupling member as described herein,
Figures 4 and 5 are a plan view and a cross-sectional view (along line V-V of Figure 4) illustrative of a coupling member as described herein,
Figure 6 and 7 are a plan view and a cross-sectional view (along line VII-VII of Figure 6) illustrative of a coupling member as described herein mounted on a power semiconductor device,
Figure 8 is illustrative of a possible step in the manufacturing process of a plurality of semiconductor devices,
Figures 9 to 14 are plan views (Figures 9, 11 and 13) and cross-sectional views (Figures 10, 12 and 14) illustrative of embodiments of the present description, wherein Figure 10 is a cross-sectional view along line X-X of Figure 9, Figure 12 is a cross-sectional view along line XII-XII Figure 11, and Figure 14 is a cross-sectional view along line XIV-XIV of Figure 13.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular conformations, structures, or characteristics may be combined in any adequate way in one or more embodiments.

The headings/references used herein are provided merely for convenience and hence do not define the extent of protection or the scope of the embodiments.

For simplicity and ease of explanation, throughout this description, and unless the context indicates otherwise, like parts or elements are indicated in the various figures with like reference signs, and a corresponding description will not be repeated for each and every figure.

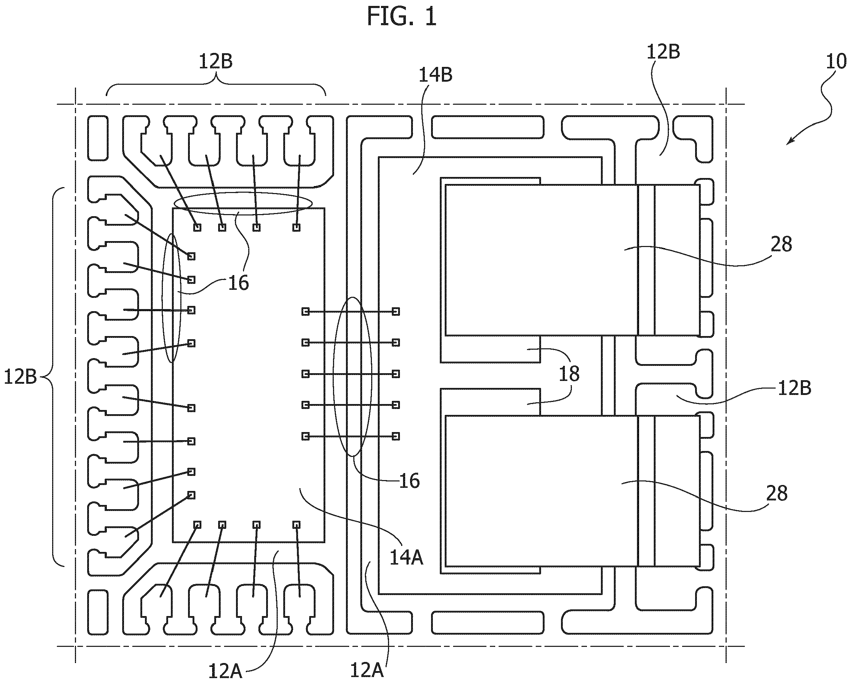

Figure 1 illustrates the structure of a (integrated circuit, IC) power semiconductor device 10 comprising a low-power section (illustrated on the left-hand side of Figure 1) comprising, for instance, a controller die or chip 14A, attached on a first die pad 12A in a leadframe 12 and a high-power section (illustrated on the right-hand side of Figure 1) comprising, for instance, one or more power dice or chips 14B attached on one or more die pads 12A in the lead frame 12.

An array of leads 12B is arranged around the die pads 12A having the low-power 14A and the high-power 14B dice mounted thereon.

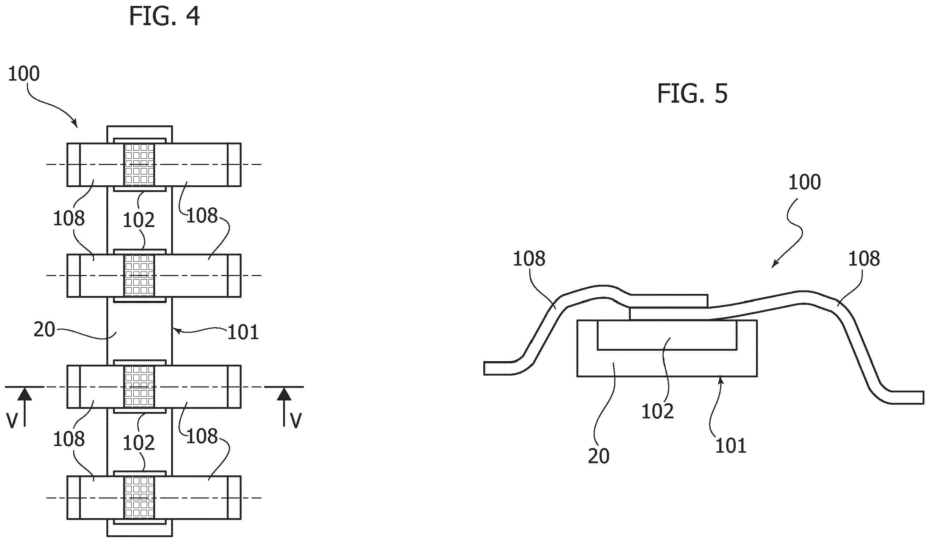

As illustrated herein by way of example, a semiconductor device such as the device 10 comprises, in addition to a substrate (leadframe) 12 having one or more semiconductor chips or dice 14A, 14B (as used herein, the terms chip/s and die/dice are regarded as synonymous) arranged thereon:
electrically conductive formations (wires, ribbons, clips) 16, 28 coupling the semiconductor dice 14A, 14B to leads (outer pads) 12B in the substrate, and
an insulating encapsulation (an epoxy resin for instance, visible in Figures 4, 7, 9 and 11 and designated there with reference 22) molded on the assembly thus formed to complete the protective plastic body of the device 10.

The designation "leadframe" (or "lead frame") is currently used (see, for instance the USPC Consolidated Glossary of the United States Patent and Trademark Office) to indicate a metal frame that provides support for an integrated circuit chip or die as well as electrical leads to interconnect the integrated circuit in the die or chip to other electrical components or contacts.

Essentially, a leadframe 12 comprises an array of electrically-conductive formations (or leads) 12B that from an outline location extend inwardly in the direction of a semiconductor chip or die (such as, 14A or 14B, for instance) thus forming an array of electrically-conductive formations from a die pad 12A configured to have at least one semiconductor chip or die attached thereon. This may be via conventional means such as a die attach adhesive (a die attach film or DAF, for instance).

In certain cases, a leadframe can be of the pre-molded type, that is a type of leadframe comprising a sculptured metal (e.g., copper) structure formed by etching a metal sheet and comprising empty spaces that are filled by a resin "pre-molded" on the sculptured metal structure.

The current transferred from the high-power section to the output pads 12B of the device can be significant. As shown on the right-hand side of Figure 1, clips 28 are thus used for that purpose in the place of wires. Wires 16 can still be used, as shown on the left-hand side of Figure 1, to provide electrical coupling to a low-power section (a controller die, for instance) in the device.

That is, as illustrated in Figure 1, electrically conductive formations are provided comprising wire bonding patterns 16 coupling the low-power section (left-hand side of Figure 1) to selected ones of the leads 12B. These wire bonding patterns are coupled to die (bonding) pads provided at the front or top surfaces of the chips (not visible in the figures for scale reasons).

Conversely, clips 28 are used to couple the high-power section (right-hand side of Figure 1) to selected ones of the leads 12B acting as (power) output pads of the device 10. Using clips in the place of wires accounts for the fact that the current transferred from the high-power section to the output pads in a power semiconductor device may be significant.

According to a conventional approach, clips 28 as illustrated, for instance, in Figure 1, are formed by stamping flat metallic (copper, for instance) material.

Clips are conventionally provided with centering features that facilitate mounting and keeping clips 28 in position during processing. Pins may be provided, via punching for instance, at the terminal portion of the clips which will be coupled to respective leads 12B provided with recessed portions at corresponding locations.

Due to the relatively small dimensions of current semiconductor devices, centering features such as pins, are increasingly difficult to provide via conventional stamping tools; In certain devices pins cannot be provided when more than two power channels are desired.

According to another conventional approach, ribbons, that is, electrically conductive (of a metallic material such as copper or a copper alloy, for instance) strip-like formations, are used to provide the desired (power) electrical couplings between a power semiconductor die 14B and power leads 12B.

The terminal parts of the ribbons may be bonded to the underlying die bonding pads 18 or leads 12B via ultrasonic wedge-bonding technique in order to form the desired electrical couplings and to keep the ribbons in position during processing of the devices.

Ultrasonic wedge-bonding is essentially based on the application of ultrasound and (mechanical) pressure to form an electrical connection between the terminal part of a ribbon and an underlying surface.

While advantageous for certain aspects, wedge-bonding may have undesired effects on the device structure as a consequence of the mechanical stress applied during bond formation.

The mechanical stress applied in the wedge bonding step may have detrimental effect on both the leadframe 12 and the semiconductor die 14B, possibly resulting in deformation of the leadframe 12 and/or cratering of the semiconductor die 14B at the die bonding pad 18 thereof. Such undesired effects may cause failure and rejection of the device under processing.

In solutions as described herein, an electrical coupling member is provided to electrically couple a semiconductor die to one or more (power) leads.

In solutions as described herein, an electrical coupling member may be provided via premolding technology.

Solutions as described herein contemplate providing a leadframe, mounting a die thereon, applying an electrical coupling member to form electrical connections between the die and leads in the leadframe.

An electrical coupling member as described herein may be formed via pre-molding techniques, similar to processing to provide pre-molded leadframe.

As known to those skilled in the art, in the manufacturing process of pre-molded leadframes, a plurality of individual leadframes may be arranged in a leadframe reel (that is, a common substrate) to facilitate concurrent processing thereof.

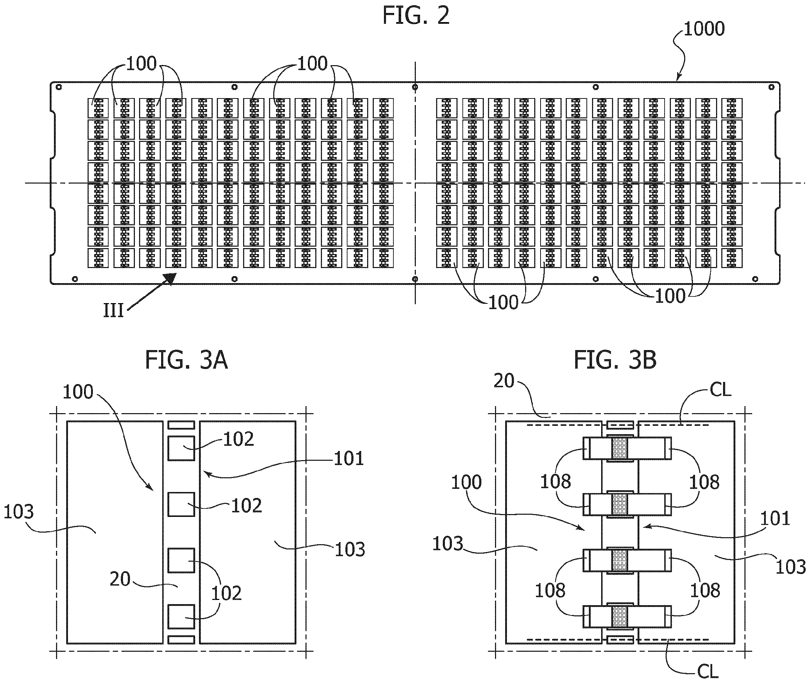

In a similar way, a plurality of coupling members 100 may be concurrently processed by providing a coupling reel 1000 as illustrated in Figure 2, the coupling reel 1000 comprising a plurality of individual coupling members 100.

Figures 3A and 3B are enlarged views of the portion of the coupling reel 1000 indicated by the arrow III, illustrative of processing steps in manufacturing a coupling member 100 according to embodiments of the present description.

As illustrated in Figure 3A a portion of a coupling reel 1000 comprises an outer frame of an electrically insulating pre-molding compound 20.

An elongated main body 101 of electrically insulating pre-molding compound 20 is supported by the outer frame and divides the region comprised in the outer frame into two empty regions 103.

The main body 101 is provided with electrically metal (copper, for instance) pads 102 exposed, that is, left uncovered by the pre-molding compound 20, at a first surface of the main body 101 of electrically insulating compound 20.

As mentioned, conventional pre-molding techniques may be used to form a coupling reel 1000 having reel portions as illustrated in Figure 3A; a metal (copper, for instance) sheet may be processed via a first (photo)etching step to form a sculptured structure comprising empty spaces that are filled with a resin "pre-molded" on the sculptured metal structure. A second (photo)etching step may be performed to etch away additional metallic material, thus forming additional features in the sculptured structure (such as the empty regions 103).

Figure 3B illustrates a processing step wherein electrically conductive ribbons 108 are attached to the main body 101 of the coupling member 100.

As exemplified in the figure, two ribbons 108 may be attached to each metal pad 102 exposed at the first surface of the main body 101 of the coupling member 100. Ribbons 108 may be attached via conventional (ultrasonic) wedge-bonding techniques, for instance.

More in detail, a first ribbon 108 may be wedge-bonded at its (proximal) terminal portion on a metal pad 102 exposed at the first surface of the main body 101. A second ribbon 108 may be wedge-bonded on the terminal end of the first ribbon 108 (wedge-on-wedge) previously welded on the metal pad 102, as illustrated in Figure 3B. The distal terminal portions of the ribbons 108 are configured to contact a die bonding pad 18 of the (IC) semiconductor die 14B and a lead 12B.

In the exemplary case, two ribbons 108 are attached to each of the four metal pads 102 in order to provide, as described in the following, four (high-current) electrical couplings between the semiconductor die 14B and the leads 12B.

For simplicity and ease of explanation, the case will be considered in the following description of a coupling member 100 with four high-current electrical couplings. This is by way of example only, as a different number or a different layout of couplings may be suggested by device design.

Cutting (with a saw or blade, for instance) along cutting lines referenced with the reference CL in Figure 3B results in an individual coupling member 100 as illustrated in Figures 4 and 5 (wherein Figure 5 is a cross-sectional view along line V-V of Figure 4).

As illustrated in Figure 5, metal pads 102 may be left uncovered by the electrically insulating (pre-)molding compound at the first surface of the main body 101 and covered with the (pre-)molding compound 20 at the second surface (opposite the first surface) of the main body 101 of the coupling member 100.

Said otherwise, a coupling member 100 as described herein comprises (at least) one electrically conductive pad 102 having first and second electrically conductive ribbons 108 protruding therefrom, the first and second electrically conductive ribbons 108 having proximal ends at the electrically conductive pad 102 and distal ends away from the electrically conductive pad 102.

The distal ends of the first and second electrically conductive ribbons 108 are configured to be electrically coupled to a semiconductor die (such as the semiconductor die 14B) arranged at the die mounting location 12A of the leadframe 12 and to the (at least one) electrically conductive lead 12B, respectively.

The electrical coupling member 100 may comprise an electrically insulating body 101 that leaves the electrically conductive pads 102 exposed at a side portion of the electrically insulating body 101. The proximal ends of the first and second electrically conductive ribbons 108 are arranged at the side portion of the electrically insulating body 101 where the electrically conductive pads 102 are left exposed.

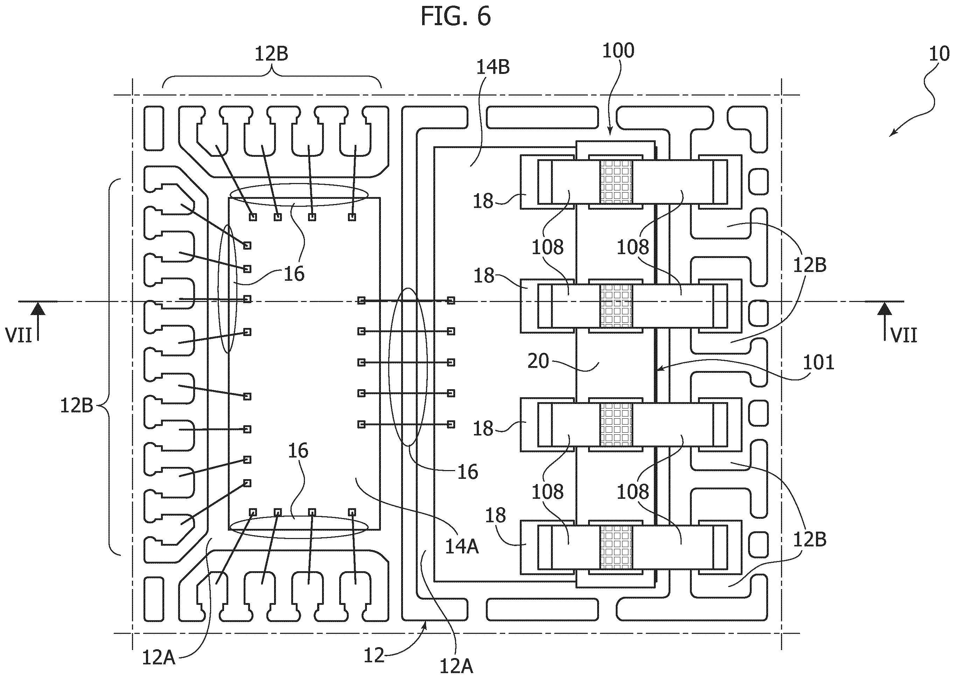

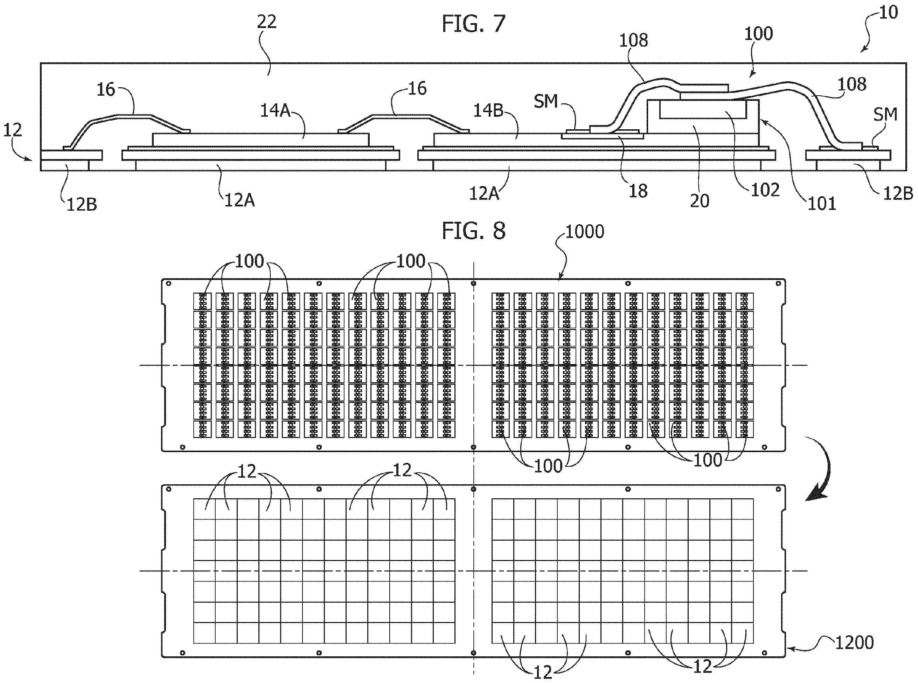

Figures 6 and 7 (where Figure 7 is a cross-sectional view along line VII-VII of Figure 6) illustrate a coupling member 100 applied on a leadframe 12 having a (power) semiconductor die 14B mounted thereon to provide the desired electrical couplings between the semiconductor die 14B and the leads 12B.

As illustrated, size and dimension of the coupling member 100 and its parts as well as the position of metal pads 102 (and consequently, the position of the ribbons 108) may be chosen in such a way to match the position of the die bonding pads 18 and the leads 12B and the distance therebetween.

The distal terminal portions of the ribbons 108 are attached to the die bonding pads 18 and the leads 12B by providing solder material SM thereon.

As illustrated in Figure 6 two ribbons 108, having one of their ends welded at the metal pad 102 exposed at the first surface of the main body 101 of the coupling member 100, provide an electrical coupling between a die bonding pad 18 provided on the top/front surface of a (power) semiconductor die 14B and a (power) lead 12B.

It may be appreciated that handling, centering and keeping in position a coupling member 100 as described herein is considerably easier than individual clips. Moreover, the coupling member 100 may be provided with centering features (such as pins, not illustrated in the figures for simplicity) in order to facilitate positioning of the coupling member 100.

In summary, a manufacturing process as described herein comprises:
arranging a semiconductor die 14B at a die mounting location (that is, a die pad) 12A of a substrate (a leadframe, for instance) 12, where the substrate 12 comprises an array of electrically conductive leads 12B arranged laterally of the die mounting location 12A.
electrically coupling the semiconductor die 14B arranged at the die mounting location 12A of the substrate 12 with one (or more) electrically conductive lead(s) 12B in the array of electrically conductive leads 12B via an electrical coupling member 100 applied onto the semiconductor die 14B.

The electrical coupling member 100 comprises one (or more) electrically conductive pad(s) 102 having first and second electrically conductive ribbons 108 protruding therefrom. The first and second electrically conductive ribbons 108 have their proximal ends at the electrically conductive pad 102 and their distal ends away from the electrically conductive pad 102.

The distal ends of the first and second electrically conductive ribbons 108 are thus electrically coupled to the semiconductor die 14B arranged at the die mounting location 12A of the substrate 12 and to the electrically conductive lead 12B, respectively, to provide electrical coupling therebetween.

Further processing of an (integrated circuit) semiconductor device as illustrated in Figure 6, for instance, may involve molding an electrically insulating compound to provide a protective encapsulation to the device. The encapsulation is illustrated in Figure 7, for instance, and referenced therein with the reference 22.

As mentioned, concurrent processing of a plurality of coupling members 100 may involve providing a coupling reel comprising a plurality of such coupling members 100.

Figure 8 illustrates a possible processing step where a plurality of coupling members 100 are concurrently mounted on a corresponding plurality of leadframes 12 having respective semiconductor dice arranged thereon.

As illustrated, a coupling reel 1000 comprising a plurality of coupling members 100 may be mounted on a leadframe reel 1200; each coupling reel 1000 portion (comprising an individual coupling member 100) may be matched to a corresponding leadframe reel 1200 portion (comprising an individual leadframe 12).

Such a processing step may be facilitated by providing the reels 1000, 1200 with centering features such as pins and corresponding recessed portions (not visible for simplicity).

After applying the coupling reel 1000 on the leadframe reel 1200, the desired electrical couplings may be provided for each portion of the reels by electrically couple the distal ends of the ribbons 108 of the individual coupling members 100 comprised in the coupling reel 1000 to the die bonding pads 18 and leads 12B of the corresponding individual leadframe 12 comprised in the leadframe reel 1200, similarly to what has been discussed in the case of an individual coupling member 100 mounted on an individual leadframe 12.

The reels 1000, 1200 may be further processed in order to concurrently process a plurality of devices and finally singulated in order to obtain a plurality of individual, processed devices.

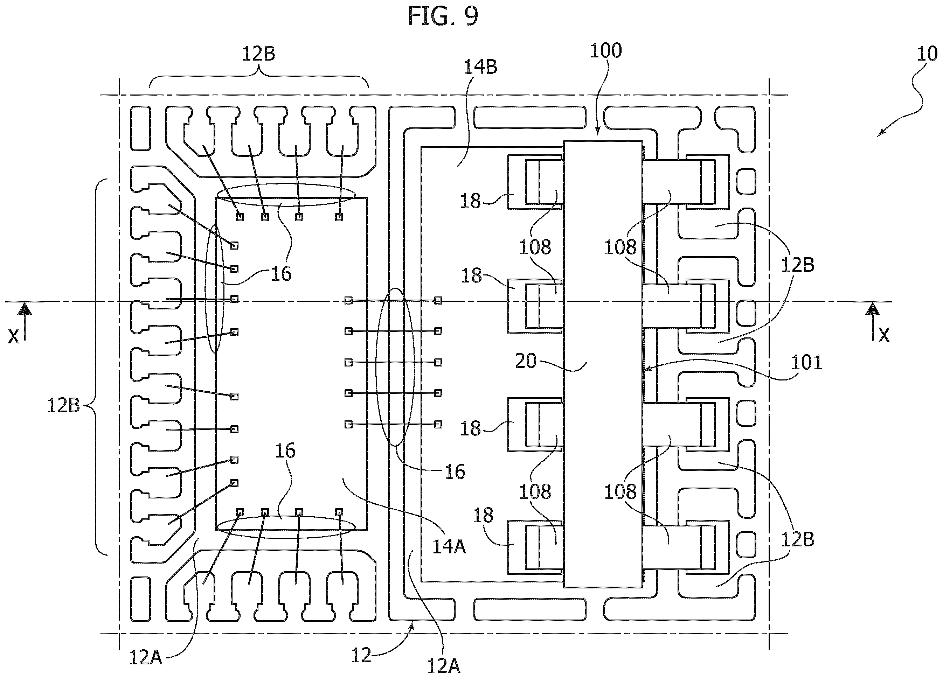

Figures 9 to 14 are illustrative of other possible embodiments of the present description.

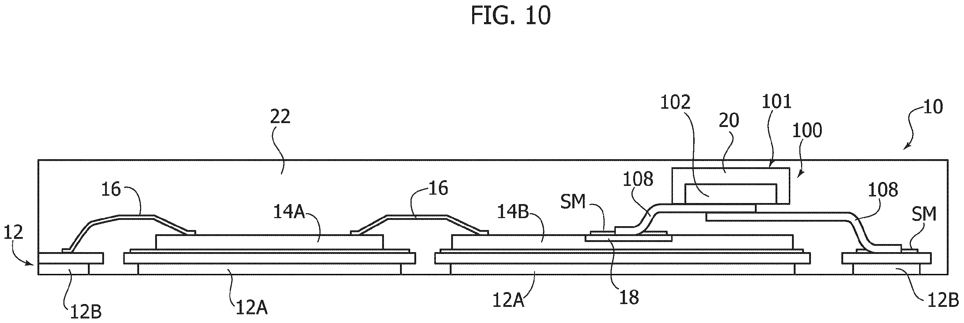

Figures 9 and 10 (wherein Figure 10 is a cross-sectional view along line X-X of Figure 9) illustrate an embodiment where a coupling member 100 is mounted with the metal pads 102 (and the ribbons 108 attached thereto) facing the semiconductor die 14B mounted on a leadframe 12.

Ribbons 108 may be attached to die bonding pads 18 and leads 12B as described in the foregoing, that is, providing solder material SM such as a solder paste or glue.

As illustrated in Figure 10, an insulating, protective encapsulation 22 may be provided to the device 10 by molding an insulating molding compound (such as an epoxy resin, for instance) onto the assembly.

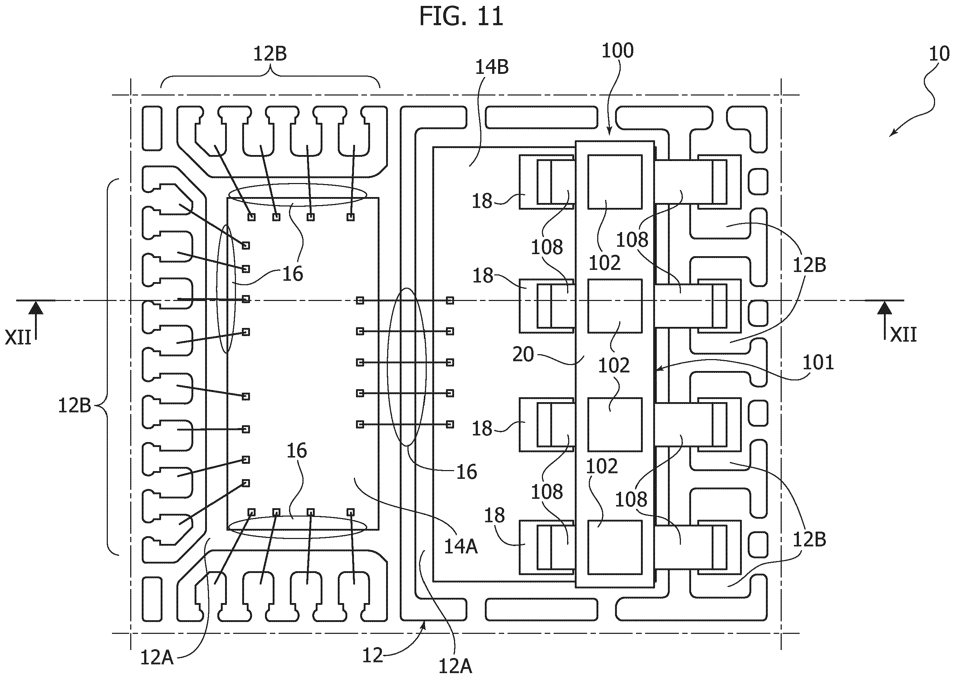

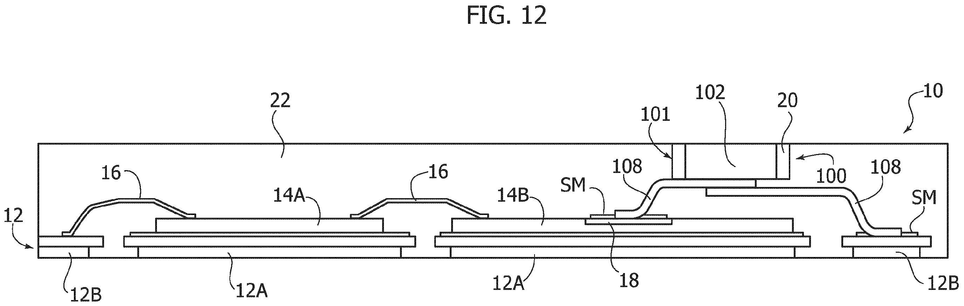

Figures 11 and 12 (where Figure 12 is a cross-sectional view along line XII-XII of Figure 11) illustrate and embodiment of the present description where a coupling member 100 has metal pads 102 left uncovered by the pre-molding compound 20 on both first and second surfaces of the main body 101 of the coupling member 100.

Such a coupling member 100 may be applied to a semiconductor die 14B with the first surface of the main body 101 facing the semiconductor die 14B, as illustrated in Figure 11.

As illustrated in Figure 12, an electrically insulating encapsulation 22 may be provided in such a way to leave the metal pads 102 exposed at the top/front surface of the device 10.

That is, the electrical coupling member may be formed in such a way that the electrically insulating body 101 leaves the electrically conductive pads 102 exposed at a further side portion of the electrically insulating body 101 opposite the side portion at which the proximal ends of the first and second electrically conductive ribbons 108 are arranged.

The insulating encapsulation 22 molded onto the semiconductor die 14B and onto the electrical coupling member 100 may leave uncovered the electrically conductive pads 102 exposed at the further side portion of the electrically insulating body 101.

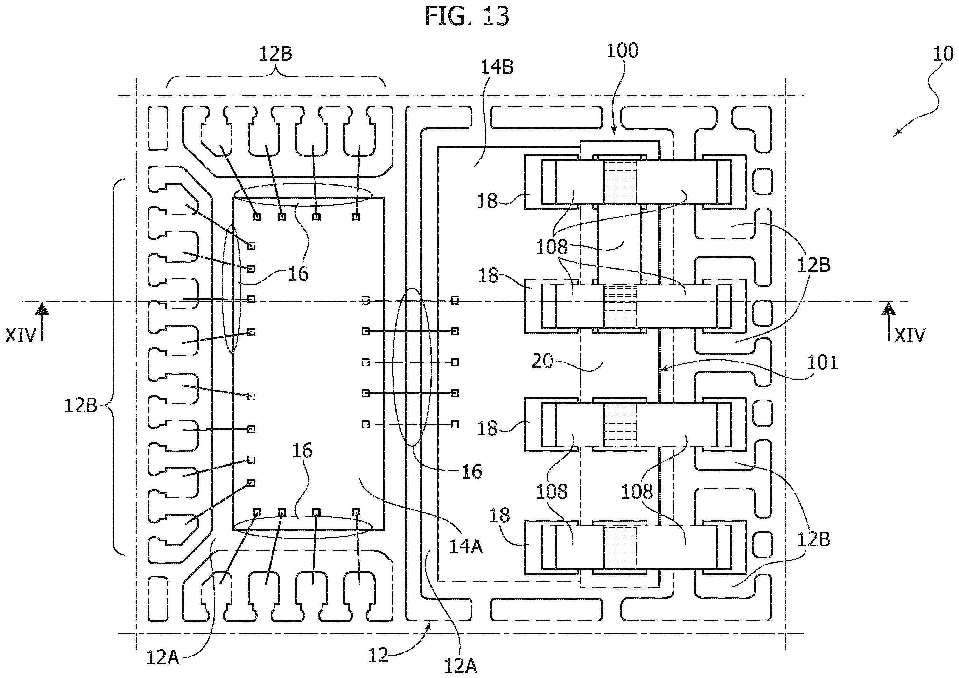

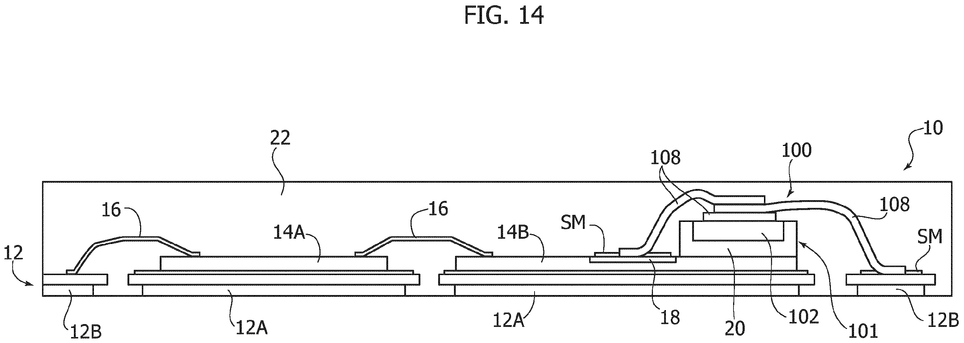

Figures 13 and 14 (where Figure 14 is a cross-sectional view along line XIV-XIV of Figure 13) illustrated an embodiment where two power channels are short circuited ("shorted").

Such a short circuit may be obtained by providing a third ribbon 108 electrically coupling two neighboring metal pads 102.

In the example illustrated in Figures 13 and 14, a first ribbon 108 has its terminal ends wedge-bonded on two neighboring metal pads 102, thus providing a short circuit therebetween. Additional ribbons 108 are welded (wedge-on-wedge bonded) to provide the electrical couplings in a similar way to what has been described in the foregoing.

Without prejudice to the underlying principles, the details and embodiments may vary, even significantly, with respect to what has been described by way of example only without departing from the extent of protection. The extent of protection is determined by the annexed claims.

## Claims

1. A method, comprising:
arranging a semiconductor die (14B) at a die mounting location (12A) of a substrate (12), the substrate (12) comprising an array of electrically conductive leads (12B) arranged laterally of the die mounting location (12A),
electrically coupling the semiconductor die (14B) arranged at the die mounting location (12A) of the substrate (12) with at least one electrically conductive lead (12B) in the array of electrically conductive leads (12B) via an electrical coupling member (100) applied onto the semiconductor die (14B),
wherein:
the electrical coupling member (100) comprises a plurality of electrically conductive pads (102) having respective first and second electrically conductive ribbons (108) protruding therefrom, the first and second electrically conductive ribbons (108) having proximal ends at the electrically conductive pad (102) and distal ends away from the electrically conductive pad (102), and
the method comprises electrically coupling the distal ends of the respective first and second electrically conductive ribbons (108) to the semiconductor die (14B) arranged at the die mounting location (12A) of the substrate (12) and to respective electrically conductive leads (12B), to provide electrical coupling therebetween.

2. The method of claim 1, comprising electrically coupling neighboring electrically conductive pads (102) in said plurality of electrically conductive pads (102) via a third electrically conductive ribbon (108).

3. The method of any of the previous claims, wherein the electrical coupling member (100) comprises an electrically insulating body (101) leaving the plurality of electrically conductive pads (102) exposed at a side portion of the electrically insulating body (101), wherein the proximal ends of the first and second electrically conductive ribbons (108) are arranged at said side portion of the electrically insulating body (101) .

4. The method of any of the previous claims, comprising molding an insulating encapsulation (22) onto the semiconductor die (14B) arranged at the die mounting location (12A) of the substrate (12) as well as onto the electrical coupling member (100) applied onto the semiconductor die (14B).

5. The method of claim 3 and claim 4, wherein the electrically insulating body (101) leaves the plurality of electrically conductive pads (102) exposed at a further side portion of the electrically insulating body (101) opposite said side portion at which the proximal ends of the first and second electrically conductive ribbons (108) are arranged, and
the method comprises molding said insulating encapsulation (22) onto the semiconductor die (14B) arranged at the die mounting location (12A) of the substrate (12) as well as onto the electrical coupling member (100) applied onto the semiconductor die (14B) with the insulating encapsulation (22) leaving uncovered the plurality of electrically conductive pads (102) exposed at said further side portion of the electrically insulating body (101).

6. The method of any of the previous claims, comprising:
providing a first reel (1200) carrying a first array of semiconductor dice (14B) arranged at respective die mounting locations (12A) of a substrate (12) and respective electrically conductive leads (12B) arranged laterally of the die mounting locations (12A),
providing a second reel (1000) carrying a second array of electrical coupling members (100) configured to electrically couple the semiconductor dice (14B) with the respective electrically conductive leads (12B) in the first reel (1200),
arranging the first reel (1200) and the second reel (1000) in a face-to-face relationship wherein the electrical coupling members (100) in the second array are applied onto respective ones of the semiconductor dice (14B) in the first array, and
electrically coupling the distal ends of the first and second electrically conductive ribbons (108) of the electrical coupling members (100) of the second reel (1000) to the semiconductor dice (14B) arranged at the die mounting locations (12A) of the substrate (12) and to the electrically conductive leads (12B) of the first reel (1000), respectively, to provide electrical coupling therebetween.

7. An electrical coupling member (100) configured to electrically couple a semiconductor die (14) arranged at a die mounting location (12A) of a substrate (12) with at least one electrically conductive lead (12B) arranged laterally of the die mounting location (12A),
wherein:
the electrical coupling member (100) comprises a plurality of electrically conductive pads (102) having respective first and second electrically conductive ribbons (108) protruding therefrom, the first and second electrically conductive ribbons (108) having proximal ends at the electrically conductive pad (102) and distal ends away from the electrically conductive pad (102), and
wherein the distal ends of the respective first and second electrically conductive ribbons (108) are configured to be electrically coupled to said semiconductor die (14B) arranged at the die mounting location (12A) of the substrate (12) and to respective electrically conductive lead (12B), to provide electrical coupling therebetween.

8. The electrical coupling member (100) of claim 7, comprising electrically coupling neighbouring electrically conductive pads (102) in said plurality of electrically conductive pads (102) via a third electrically conductive ribbon (108).

9. The electrical coupling member (100) of claim 7 or claim 8, wherein the electrical coupling member (100) comprises an electrically insulating body (101) leaving the plurality of electrically conductive pads (102) exposed at a side portion of the electrically insulating body (101), wherein the proximal ends of the first and second electrically conductive ribbons (108) are arranged at said side portion of the electrically insulating body (101).

10. A semiconductor device (10), comprising:
a semiconductor die (14) arranged at a die mounting location (12A) of a substrate (12) with at least one electrically conductive lead (12B) arranged laterally of the die mounting location (12A), and
an electrical coupling member (100) comprising a plurality of electrically conductive pads (102) having respective first and second electrically conductive ribbons (108) protruding therefrom, the respective first and second electrically conductive ribbons (108) having proximal ends at the electrically conductive pad (102) and distal ends away from the electrically conductive pad (102),
wherein the distal ends of the first and second electrically conductive ribbons (108) are electrically coupled to said semiconductor die (14B) arranged at the die mounting location (12A) of the substrate (12) and to respective electrically conductive leads (12B), to provide electrical coupling therebetween.

11. The semiconductor device (10) of claim 10, wherein the electrical coupling member (100) comprises an electrically insulating body (101) leaving the plurality of electrically conductive pads (102) exposed at a side portion of the electrically insulating body (101), wherein the proximal ends of the first and second electrically conductive ribbons (108) are arranged at said side portion of the electrically insulating body (101) .

12. The semiconductor device (10) of claim 10 or claim 11, comprising an insulating encapsulation (22) molded onto the semiconductor die (14B) arranged at the die mounting location (12A) of the substrate (12) as well as onto the electrical coupling member (100) applied onto the semiconductor die (14B).

13. The semiconductor device (10) of claim 11 and claim 12, wherein the electrically insulating body (101) leaves the plurality of electrically conductive pads (102) exposed at a further side portion of the electrically insulating body (101) opposite said side portion at which the proximal ends of the first and second electrically conductive ribbons (108) are arranged, and
the insulating encapsulation (22) leaves uncovered the plurality of electrically conductive pad (102) exposed at said further side portion of the electrically insulating body (101).
